(19) Europäisches Patentamt
European Patent Office
Office européen des brevets

(11) **EP 4 611 018 A1**

(12) **EUROPEAN PATENT APPLICATION**

(43) Date of publication:
**03.09.2025 Bulletin 2025/36**

(51) International Patent Classification (IPC):
**H01H 47/00** $^{(2006.01)}$

(21) Application number: **24160406.5**

(52) Cooperative Patent Classification (CPC):
**H01H 47/002**

(22) Date of filing: **29.02.2024**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **VOLVO TRUCK CORPORATION**
**405 08 Göteborg (SE)**

(72) Inventor: **GIL RUBIO, Diego**
**414 57 Göteborg (SE)**

(74) Representative: **Kransell & Wennborg KB**
**P.O. Box 2096**
**403 12 Göteborg (SE)**

(54) **SYSTEM AND METHOD FOR WELD CHECK OF CONTACTORS**

(57) A computer system (100) comprising processing circuitry (106) configured to: request opening of a positive contactor (102) and a negative contactor (104), acquire measurements of a first voltage (v1), a second voltage (v2), a third voltage (v3), and a fourth voltage (v4) between a positive pole (124) and a negative pole (126), and ground, calculate a first contactor voltage ($V_{contactor1}$) across one of the negative contactor (104) and the positive contactor (102) and a second contactor voltage ($V_{contactor2}$) across the other one of the negative contactor (104) and the positive contactor (102), determine that one or more of the positive contactor (102) and the negative contactor (104) is welded when the respective one of the first contactor voltage ($V_{contactor1}$) and the second contactor voltage ($V_{contactor2}$) fulfill the voltage criterion.

Fig. 1

## Description

### TECHNICAL FIELD

The disclosure relates generally to electrical contactors for electrical energy storage devices. In particular aspects, the disclosure relates to a system and method for weld check of contactors. The disclosure can be applied to heavy-duty vehicles, such as trucks, buses, and construction equipment, among other vehicle types such as marine vessels. The present disclosure is also applicable to stationary applications and passenger vehicles such as cars. Although the disclosure may be described with respect to a particular vehicle, the disclosure is not restricted to any particular vehicle.

### BACKGROUND

During rapid opening or closing of a switch or contactor an arc is formed between the contacts of the contactor that may fluidize the material of the contacts that cause them to stick together. Alternatively, if a too large electrical current is pushed through the main contacts this may also cause welding. In either case, welding prevents opening of the contactor.

It is desirable to in a fast and reliable way check whether welding has occurred, especially for contactors of electrical vehicles, such as fully electric vehicles or hybrid vehicles, such that unnecessary operation delays can be avoided.

### SUMMARY

According to a first aspect of the disclosure, there is provided a computer system comprising processing circuitry configured to: request opening of a positive contactor and a negative contactor arranged to controllably connect an electrical energy storage system to a load, acquire measurements of a first voltage between the positive pole and the negative pole on the electrical energy storage system side of the contactors, a second voltage between one of the positive pole or the negative pole and ground on the electrical energy storage system side of the contactors, a third voltage between the positive pole and the negative pole on the load side of the contactors, and a fourth voltage between one of the positive pole or the negative pole and ground on the load side of the contactors, calculate a first contactor voltage across one of the negative contactor and the positive contactor and a second contactor voltage across the other one of the negative contactor and the positive contactor based on the first measured voltage, the second measured voltage, the third measured voltage, and the fourth measured voltage, evaluate the first contactor voltage and the second contactor voltage in view of a voltage criterion, determine that one or more of the positive contactor and the negative contactor is welded when the respective one of the first contactor voltage and the second contactor voltage fulfills the voltage criterion, and provide an output indicating that one or more of the positive contactor and the negative contactor is welded.

The first aspect of the disclosure may seek to perform a weld test of a positive and negative contactor connected to an electrical energy storage system in reduced amount of time. A technical benefit may include that the downtime of the equipment or vehicle using the electrical energy storage system is reduced while performing weld testing of the contactors. Furthermore, the proposed test does not require closing and opening of the contactors, that is, the contactors are requested to remain in an open state, thereby reducing the wear on the contractors and therefore improves their lifetime. That is, no active control of the negative contactor and the positive contactor is performed during the weld testing sequence.

Optionally in some examples, including in at least one preferred example, the voltage criterion may be that one or more of the first contactor voltage and the second contactor voltage is below or equal to a voltage threshold. The threshold is set very low, for example at zero, or just above zero with some margin to account for e.g., noise, hardware tolerances, offset errors, gain errors, and other system or measurement parameters. The contactors may be assumed to be open and the electrical current to be at zero output, whereby this provides a simple yet robust way to detect welding which would cause a nearly zero voltage across the contactors. Thus, the voltage criterion may be that one or more of the first contactor voltage and the second contactor voltage is close to zero. On the other hand, if the contactor voltage of either one of the first contactor and the second contactor is higher than the threshold, then a pass signal may be provided by the processing circuitry indicating that no welding has occurred and the contactors work as expected.

Optionally in some examples, including in at least one preferred example, the processing circuitry may be further configured to: calculate the first contactor voltage as a difference between the second measured voltage and the fourth measured voltage. This provides one advantageous, e.g. simple and reliable way to calculate the first contactor voltage.

Optionally in some examples, including in at least one preferred example, the processing circuitry may be further configured to: calculate the second contactor voltage as a difference between a first difference and a second difference, the first difference being the difference between the first voltage and the second voltage, and the second difference being the difference between the third voltage and the fourth voltage. This provides one advantageous, e.g. simple and reliable way to calculate the second contactor voltage.

Optionally in some examples, including in at least one preferred example, the second voltage may be measured between ground and the negative pole on the electrical energy storage system side of the contactors, and the fourth voltage may be measured between the ground and the negative pole on the load side of the contactors, the processing circuitry is configured to: calculate the first contactor voltage across the negative contactor as the difference between the second voltage and the fourth voltage, and calculate the second contactor voltage across the positive contactor as the difference between a first difference between the measured first voltage and the measured second voltage and a second difference between the measured third voltage and the measured fourth voltage. This provides one advantageous, e.g. simple and reliable way to calculate the second contactor voltage and the first contactor voltage.

Optionally in some examples, including in at least one preferred example, the second voltage may be measured between the positive pole and ground on the electrical energy storage system side of the contactors, and the fourth voltage being measured between the positive pole and ground on the load side of the contactors, the processing circuitry is configured to: calculate the first contactor voltage across the positive contactor as the difference between the second voltage and the fourth voltage, and calculate the second contactor voltage across the negative contactor as the difference between a first difference between the measured third voltage and the measured fourth voltage and a second difference between the measured first voltage and the measured second voltage. This provides one advantageous, e.g. simple and reliable way to calculate the second contactor voltage and the first contactor voltage.

Optionally in some examples, including in at least one preferred example, the electrical energy storage system may be a propulsion electrical energy storage system of a vehicle. Thus, downtime for the vehicle can be minimized while weld testing the contactors.

Optionally in some examples, including in at least one preferred example, the processing circuitry may be further configured to: prior to acquiring the voltage measurements, determine that the electrical current output from the electrical energy storage system is at or near zero current. The electrical current output is requested to remain at zero, and no further control of the electrical current output is required, assisting in reducing the weld testing time. Furthermore, the negative contactor and the positive contactor is requested to remain in an open state throughout the weld testing time, and only in case of welding is the contactors engaged. However, no active control of the negative contactor and the positive contactor is performed during the weld testing.

There is further provided a vehicle comprising the computer system of any of the examples.

According to a second aspect of the disclosure, there is provided a computer-implemented method for detecting welded contactors of an electrical energy storage system, the method comprising: requesting, by processing circuitry of a computer system, opening of a positive contactor and a negative contactor arranged to controllably connect an electrical energy storage system to a load, acquiring, by the processing circuitry, measurements of a first voltage between the positive pole and the negative pole on the electrical energy storage system side of the contactors, a second voltage between one of the positive pole or the negative pole and ground on the electrical energy storage system side of the contactors, a third voltage between the positive pole and the negative pole on the load side of the contactors, and a fourth voltage between one of the positive pole or the negative pole and ground on the load side of the contactors, calculating, by the processing circuitry, a first contactor voltage across one of the negative contactor and the positive contactor and a second contactor voltage across the other one of the negative contactor and the positive contactor based on the first measured voltage, the second measured voltage, the third measured voltage, and the fourth measured voltage, evaluating, by the processing circuitry, the first contactor voltage and the second contactor voltage in view of a voltage criterion, determining, by the processing circuitry, that one or more of the positive contactor and the negative contactor is welded when the respective one of the first contactor voltage and the second contactor voltage fulfills the voltage criterion, and providing, by the processing circuitry, an output indicating that one or more of the positive contactor and the negative contactor is welded.

The second aspect of the disclosure may seek to perform a weld test of a positive and negative contactor connected to an electrical energy storage system in reduced amount of time. A technical benefit may include that the downtime of the equipment or vehicle using the electrical energy storage system is reduced while performing weld testing of the contactors. Furthermore, the proposed test does not require closing and opening of the contactors, that is, the contactors are requested to remain in an open state, thereby reducing the wear on the contractors and therefore improves their lifetime.

Optionally in some examples, including in at least one preferred example, the voltage criterion may be that one or more of the first contactor voltage and the second contactor voltage is below or equal to a voltage threshold. The threshold is set very low, for example at zero, or just above zero with some margin to account for e.g., noise, hardware, errors, offsets, gain, and other system or measurement parameters. The contractors may be assumed to be open and the electrical current to be at zero output, whereby this provides a simple yet robust way to detect welding which would cause a nearly zero voltage across the contactors. Thus, the voltage criterion may be that one or more of the first contactor voltage the second contactor voltage is close to zero.

Optionally in some examples, including in at least one preferred example, the method may further comprise calculating, by the processing circuitry, the first contactor voltage as a difference between the second measured voltage and the fourth measured voltage. This provides one advantageous, e.g. simple and reliable way to calculate the first contactor voltage.

Optionally in some examples, including in at least one preferred example, the method may comprise calculating, by the processing circuitry, the second contactor voltage as a difference between a first difference and a second difference, the first difference being the difference between the first voltage and the second voltage, and the second difference being the difference between the third voltage and the fourth voltage. This provides one advantageous, e.g. simple and reliable way to calculate the second contactor voltage.

Optionally in some examples, including in at least one preferred example, the second voltage may be measured between ground and the negative pole on the electrical energy storage system side of the contactors, and the fourth voltage may be measured between ground and the negative pole on the load side of the contactors, the method may comprise: calculating, by the processing circuitry, the first contactor voltage across the negative contactor as the difference between the fourth voltage and the second voltage, and calculating, by the processing circuitry, the second contactor voltage across the positive contactor as the difference between a first difference between the measured first voltage and the measured second voltage and a second difference between the measured third voltage and the measured fourth voltage. This provides one advantageous, e.g. simple and reliable way to calculate the second contactor voltage and the first contactor voltage.

Optionally in some examples, including in at least one preferred example, the second voltage may be measured between the positive pole and ground on the electrical energy storage system side of the contactors, and the fourth voltage may be measured between the positive pole and ground on the load side of the contactors, the method may comprise: calculating, by the processing circuitry, the first contactor voltage across the positive contactor as the difference between the second voltage and the fourth voltage, and calculating, by the processing circuitry, the second contactor voltage across the negative contactor as the difference between a first difference between the measured third voltage and the measured fourth voltage and a second difference between the measured first voltage and the measured second voltage. This provides one advantageous, e.g. simple and reliable way to calculate the second contactor voltage and the first contactor voltage.

Optionally in some examples, including in at least one preferred example, the positive contactor and the negative contactor are requested to remain open throughout, and at least until the output is provided. A technical benefit is that wear on the positive contactor and the negative contactor is avoided and that the weld test duration is kept short.

Optionally in some examples, including in at least one preferred example, the method may comprise prior to acquiring the voltage measurements, determining, by the processing circuitry, that the electrical current output from the electrical energy storage system is at or near zero current.

Optionally in some examples, including in at least one preferred example, the electrical energy storage system may be a propulsion electrical energy storage system of a vehicle.

There is further provided a computer program product comprising program code for performing, when executed by the processing circuitry, the method of any of the examples.

There is further provided a non-transitory computer-readable storage medium comprising instructions, which when executed by the processing circuitry, cause the processing circuitry to perform the method of any of the examples.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

## BRIEF DESCRIPTION OF THE DRAWINGS

FIG. 1 is an exemplary system diagram of a computer system for detecting welded contactors according to an example.

FIG. 2 is an exemplary system diagram of a computer system for detecting welded contactors according to an example.

FIG. 3 is an exemplary system diagram of a computer system for detecting welded contactors according to an example.

FIG. 4 is an exemplary system diagram of a computer system for detecting welded contactors according to an example.

**FIG. 5** is an exemplary truck according to an example vehicle.

**FIG. 6** is a flow chart of an exemplary method to detect welded contactors of an electrical energy storage system according to an example.

**FIG. 7** is a flow chart of an exemplary method to detect welded contactors of an electrical energy storage system according to an example.

**FIG. 8** is a schematic diagram of an exemplary computer system for implementing examples disclosed herein, according to an example.

**DETAILED DESCRIPTION**

The detailed description set forth below provides information and examples of the disclosed technology with sufficient detail to enable those skilled in the art to practice the disclosure.

Contact welding is a state in which the contacts of a contactor or switch get welded together due to high power arcs during switching operations or due to excessively high currents passing though the contactor. To assess whether welding has occurred it is advantageous if the testing duration is as short as possible to avoid unnecessary downtime of the equipment or device or vehicle employing the contactor and preferably also to reduce wear on the contactor. This is addressed by the examples discussed herein.

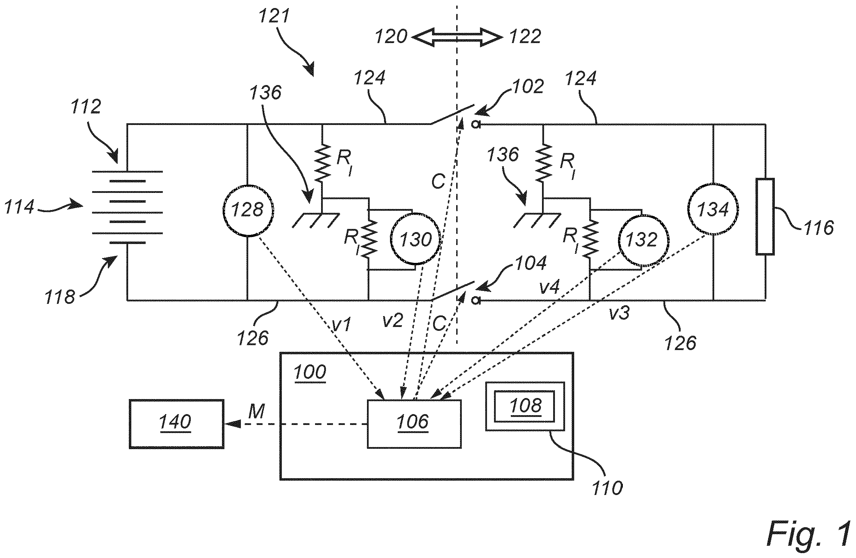

**FIG. 1** is an exemplary system diagram of a computer system 100 configured to perform weld testing on a positive contactor 102 and a negative contactor 104 according to an example.

The computer system 100 comprising processing circuitry 106 configured to perform various steps for performing the weld test. The processing circuitry 102 has access to a computer program product 108 comprising program code for performing, when executed by the processing circuitry 106, the method. For this, the processing circuitry 102 has access to a non-transitory computer-readable storage medium 110 comprising such instructions.

The positive contactor 102 and the negative contactor 104 are controllable by the processing circuitry 106 between an open state and a closed or engaged state by transmitting control messages C. In the open state, electric current is not allowed to flow through the contactors 102, 104, and in the closed or engaged state electric current is allowed to flow through the contactors 102, 104.

The positive contactor 102 is electrically connected between a positive pole electrode 112 of an electrical energy storage system 114 and a load 116. The load 116 may comprise one or more of a capacitive, inductive, and resistive load. Opening and closing the positive contactor 102 opens and closes the electrical connection between the positive pole electrode 112 of the electrical energy storage system 114 and the load 116.

The electrical energy storage system 114 may be a traction or propulsion electrical energy storage system of a vehicle, thus providing propulsion power and energy to an electrical machine 116 of the vehicle for driving the vehicle.

The negative contactor 104 is electrically connected between a negative pole electrode 118 of the electrical energy storage system 114 and the load 116. Opening and closing the positive contactor 102 opens and closes the electrical connection between the positive pole electrode 112 of the electrical energy storage system 114 and the load 116.

The circuit diagram 121 shown in fig. 1 can be considered having two sides, an electrical energy storage system side 120 and a load side 122 of the contactors 102 and 104. The electrical energy storage system side 120 is the side of the circuit where the positive 102 and negative 104 contactors receive a connection with the electrical energy storage system 114, and the side comprising the electrical energy storage system 114. The load side 122 is the side of the circuit where the positive 102 and negative 104 contactors connect with the load 116, and the side comprising load 116. The positive 102 and negative 104 contactors break the connection at the interface between the electrical energy storage system side 120 and the load side 122. Thus, the sides 120 and 122 are defined with reference to the positive 102 and negative 104 contactors.

Furthermore, the circuit 121 comprises a positive pole 124 and a negative pole 126. The negative pole 126 extends to both the electrical energy storage system side 120 and to the load side 122. The positive pole 124 extends to both the electrical energy storage system side 120 and to the load side 122.

The processing circuitry 106 is configured to acquire measurements at four points in the circuit. The measurement points can vary depending on the specific implementation of which multiple examples are described herein. The processing circuitry 106 requests voltage measurements, v1, v2, v3, v4, from voltage sensors 128, 130, 132, and 134. The sensors 128, 130, 132, and 134 may be physical sensors or virtual sensors, so-called soft sensors or model-based sensors implemented in software. Common for all disclosed examples is that the processing circuitry 106 calculate a first contactor voltage across one of the negative contactor 104 and the positive contactor 102 and a second contactor voltage across the other one of the negative contactor 104 and the positive contactor 102 based on the first measured voltage v1, the second measured voltage v2, the third measured voltage v3, and the fourth measured voltage v4, where all or only a portion of the four measurements points are used for calculating the first contactor voltage, and all or only a portion of the four measurements points are used for calculating the second contactor voltage, as will be described in specific examples herein.

In the drawings, resistances are for clarity shown between the poles 124, 126 and ground 136 across which voltages v1, v2, v3, v4, are measured. However, it is to be understood that the resistances are the isolation resistance, $R_I$, and not a resistor mounted for the purpose of measuring the voltages. The v1, v2, v3, v4, may thus also be used for performing isolation resistance measurements of the electrical energy storage system. In other words, the inventors further realized that the same voltages measured for performing isolation resistance measurements can be used also for the weld test described herein, no additional hardware is needed.

In a weld test sequence, the processing circuitry 106 requests opening of the positive contactor 102 and the negative contactor 104 arranged to controllably connect the electrical energy storage system 114 to the load 116.

The positive contactor 102 and the negative contactor 104 are preferably requested to remain open throughout the entire weld test sequence. That is no further control of the positive contactor 102 and the negative contactor 104 is required.

Preferably, the voltages v1, v2, v3, v4 are measured while the positive contactor 102 and the negative contactor 104 remain open.

In some examples, the processing circuitry 106 may determine that the electrical current output from the electrical energy storage system 114 is at or near zero before acquiring voltage measurements v1, v2, v3, v4.

The processing circuitry 106 acquires a measurement of a first voltage v1 between the positive pole 124 and the negative pole 126 on the electrical energy storage system side 120 of the positive 102 and negative 104 contactors.

In this example, the processing circuitry 106 further acquires a measurement of second voltage v2 between ground 136 and the negative pole 126 on the electrical energy storage system side 122 of the contactors 102 and 104.

In this example, the processing circuitry 106 further acquires a measurement of a third voltage v3 between the positive pole 124 and the negative pole 126 on the load side 122 of the contactors 102 and 104.

In this example, the processing circuitry 106 further acquires a measurement of a fourth voltage between ground 136 and the negative pole 126 on the load side 122 of the contactors 102 and 104.

The processing circuitry 106 calculates a first contactor voltage $V_{contactor1}$ across the negative contactor 104 based on the second measured voltage v2 and the fourth measured voltage v4. The first contactor voltage, herein being the negative contactor voltage is calculated as a difference, e.g., subtraction, between the fourth measured voltage v4 and the second measured voltage v2. This provides the voltage drop across the negative contactor 104.

The processing circuitry 106 calculates a second contactor voltage, $V_{contactor2}$, across the positive contactor 102 based on the first measured voltage v1, the second measured voltage v2, the third measured voltage v3, and the fourth measured voltage v4.

To calculate the voltage across the positive contactor 102, the voltage on both sides 120, 122 of the positive contactor 102 is needed. The difference between the voltages on both sides is the voltage drop across the positive contactor 102.

In this example, by circuit analysis, the voltage from the positive pole 124 to ground 136 is the differential between the first voltage v1 and the second voltage v2 on the electrical energy storage system side 120. Similarly, on the load side 122 of the contactors 102, 104, the voltage from the positive pole 124 to ground 136 is the differential between the third voltage v3 and the fourth voltage v4. In other words, in order to determine the voltage across the positive contactor 102, the difference between the first voltage v1 and the second voltage v2 on the electrical energy storage system side 120 is compared with the difference between the third voltage v3 and the fourth voltage v4 on the load side 120.

That is, the second contactor voltage, $V_{contactor2}$, is in this example the positive contactor voltage and is calculated as a difference between a first difference $\Delta V1$ and a second difference $\Delta V2$, where the first difference is the difference between the first voltage v1 and the second voltage v2, and the second difference $\Delta V2$ is the difference between the third voltage v3 and the fourth voltage v4.

In this example, shown in fig. 1, the following equations apply:

$$V_{(positive)\_contactor2} = v1 - v2 - (v3 - v4)$$

$$V_{(negative)\_contactor1} = v4 - v2$$

The processing circuitry 106 evaluates the first contactor voltage $V_{contactor1}$ and the second contactor voltage $V_{contactor2}$ in view of a voltage criterion.

The processing circuitry 106 determines that one or more of the positive contactor 102 and the negative contactor 104 is welded when the respective one of the first contactor voltage $V_{contactor1}$ and the second contactor voltage $V_{contactor2}$ fulfills the voltage criterion.

The voltage criterion may be that a respective one the first contactor voltage $V_{contactor1}$ and the second contactor voltage $V_{contactor2}$ is below or equal to a voltage threshold. That is, if one of the $V_{contactor1}$ and the second contactor voltage

$V_{contactor2}$ is below or equal to the voltage threshold then a violation has occurred and welding of the contactor(s) is concluded. The threshold may be set to zero but with margin to account for system noise, offsets, gains, and other errors. Thus, the voltage criterion may be that one or more of the first contactor voltage $V_{contactor1}$ and the second contactor voltage $V_{contactor2}$ is close to zero.

When a violation has occurred, the processing circuitry 106 provides an output M indicating that one or more of the positive contactor 102 and the negative contactor 104 is welded. The output M may be provided to a user interface 140 such a display or memory storage device, or to a control of the contactors 102, 104. In case of welding of one of the contactors 102, 104, the contactors 102 and 104 disabled and thus prevented from usage and therefore also the vehicle is disabled from usage. A service request may be output in the vehicle.

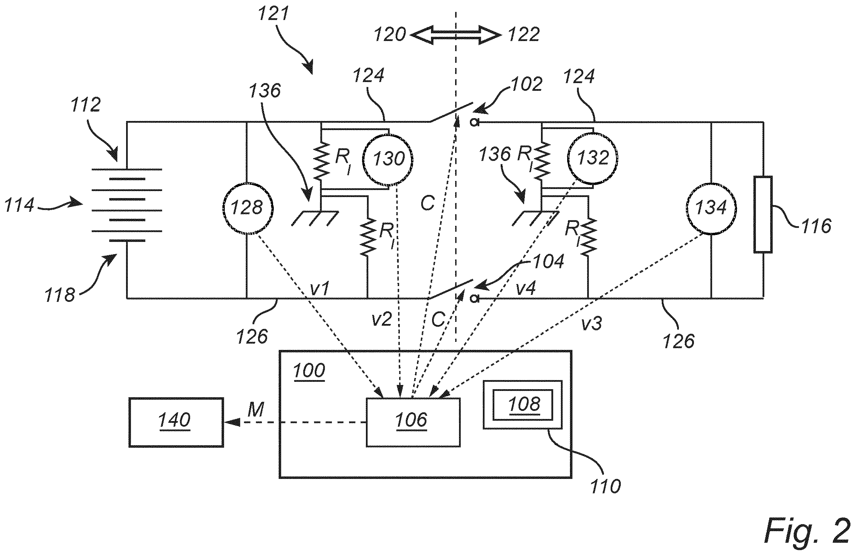

**FIG. 2** is an exemplary system diagram of a computer system 100 configured to perform weld testing on a positive contactor 102 and a negative contactor 104 according to an example. More specifically, fig. 2 illustrates another possibility with regards to the voltage measurements v1, v2, v3, v4.

In the example of fig. 2, the second voltage v2 is measured between the positive pole 124 and ground 136 on the electrical energy storage system side 120 of the contactors 102 and 104. The fourth voltage v4 is measured between the positive pole 124 and ground 136 on the load side 122 of the contactors 102 and 104.

In this example, the processing circuitry 106 is configured to calculate the first contactor voltage $V_{contactor1}$ across the positive contactor 102 as the difference between the second voltage v2 and the fourth voltage v4. That is, the first contactor voltage, here in this example being the positive contactor 102 voltage is calculated as a difference, e.g., subtraction, between the second measured voltage v2 and the fourth measured voltage v4. This provides the voltage across the positive contactor 102.

Further, the processing circuitry 106 calculates the second contactor voltage $V_{contactor2}$, across the negative contactor 104 based on the first measured voltage v1, the second measured voltage v2, the third measured voltage v3, and the fourth measured voltage v4.

To calculate the voltage across the negative contactor 104, the voltage on both sides 120, 122 of the negative contactor 104 is needed. The difference between the voltages on both sides 120, 122 is the voltage drop across the negative contactor 102.

In this example, by circuit analysis as described above, the voltage between the ground 136 and the negative pole 126 is the differential between the first voltage v1 and the second voltage v2 on the electrical energy storage system side 120. Similarly, on the load side 122 of the contactors 102, 104, the voltage between ground 136 and the negative pole 126 is the differential between the third voltage v3 and the fourth voltage v4. In other words, in order to determine the voltage across the negative contactor 102, the difference between the first voltage v1 and the second voltage v2 on the electrical energy storage system side 120 is compared with the difference between the third voltage v3 and the fourth voltage v4 on the load side 120.

That is, the second contactor voltage, $V_{contactor2}$, is in this example the negative contactor voltage and is calculated as a difference between a first difference $\Delta V1$ and a second difference $\Delta V2$, where the first difference is the difference between the third voltage v3 and the fourth voltage v3, and the second difference $\Delta V2$ is the difference between the first voltage v1 and the second voltage v2.

In this example, shown in fig. 2, the following equations apply:

$$V_{(negative)\_contactor2} = v3 - v4 - (v1 - v2)$$

$$V_{(positive)\_contactor1} = v2 - v4$$

The evaluation in view of the voltage criterion and provision of output messages M apply in the same way in this example as in the above example described with reference to fig. 1.

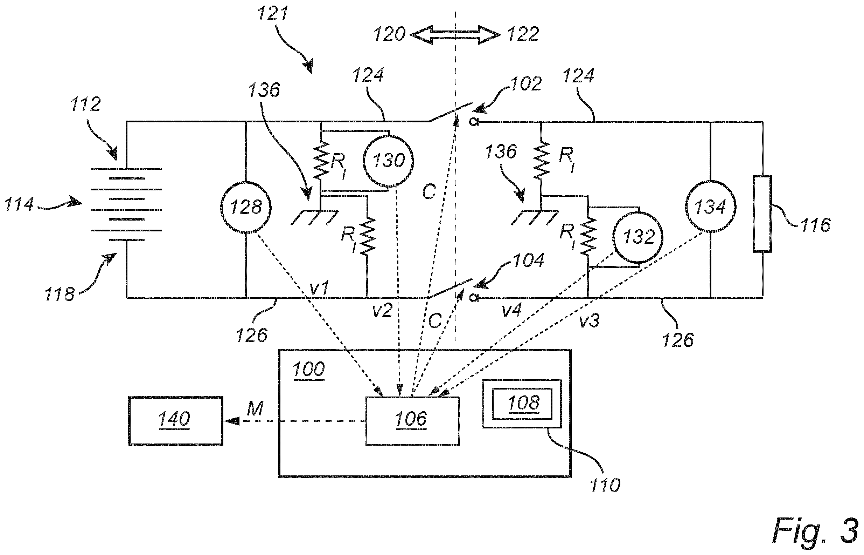

**FIG. 3** is an exemplary system diagram of a computer system 100 configured to perform weld testing on a positive contactor 102 and a negative contactor 104 according to an example. More specifically, fig. 3 illustrates another possibility with regards to the voltage measurements v1, v2, v3, v4.

In the example of fig. 3, the second voltage v2 is measured between the positive pole 124 and ground 136 on the electrical energy storage system side 120 of the contactors 102 and 104. The fourth voltage v4 is measured between ground 136 and the negative pole 126 on the load side 122 of the contactors 102 and 104.

In this example, the processing circuitry 106 is configured to calculate the first contactor voltage $V_{contactor1}$ across the positive contactor 102 based on the second voltage v2, the third voltage v3, and the fourth voltage v4. More specifically, by circuit analysis, the voltage between the positive pole 124 and ground 136 on the load side 122 is the difference between the third voltage v3 and the fourth voltage v4. That is, the first contactor voltage, here in this example being the positive contactor 102 voltage is calculated as a difference, e.g., subtraction, between the second measured voltage v2 and the difference between the third voltage v3 and the fourth voltage v4. This provides the voltage across the positive contactor 102.

Further, the processing circuitry 106 calculates the second contactor voltage $V_{contactor2}$, across the negative contactor 104 based on the first measured voltage v1, the second measured voltage v2, and the third measured voltage v3.

The voltage between the negative pole 126 and ground 136 on the electrical energy storage system side 120 is the difference between the first voltage v1 and the second voltage v2. That is, the second contactor voltage, here in this example being the negative contactor 104 voltage is calculated as a difference, e.g., subtraction, between fourth voltage v4, and the difference between the first voltage v1 and the second voltage v2. This provides the voltage across the negative contactor 104.

In this example, shown in fig. 3, the following equations apply:

$$V_{(negative)\_contactor2} = v4 - (v1 - v2)$$

$$V_{(positive)\_contactor1} = v2 - (v3 - v4)$$

The evaluation in view of the voltage criterions and provision of output messages M apply in the same way in this example as in the above example described with reference to fig. 1.

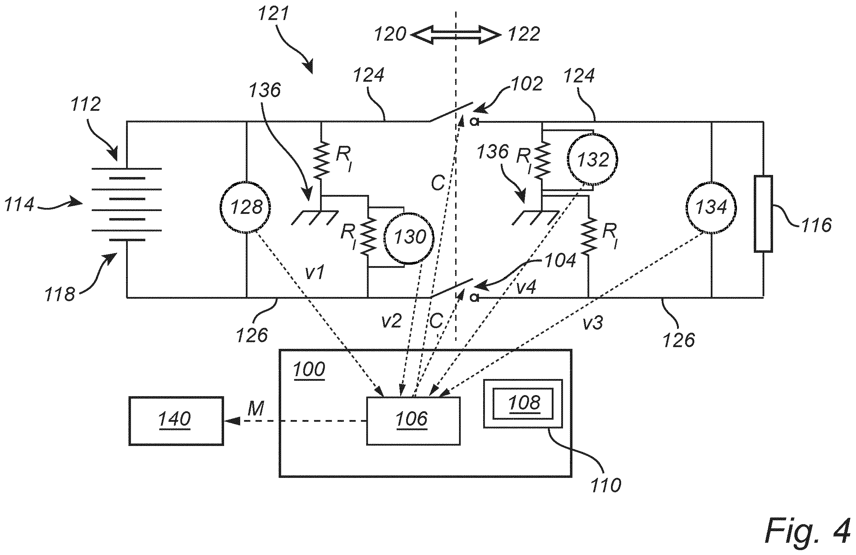

FIG. 4 is yet another exemplary system diagram of a computer system 100 configured to perform weld testing on a positive contactor 102 and a negative contactor 104 according to an example. More specifically, fig. 4 illustrates another possibility with regards to the voltage measurements v1, v2, v3, v4.

In the example of fig. 4, the second voltage v2 is measured between ground and the negative pole 126 on the electrical energy storage system side 120 of the contactors 102 and 104. The fourth voltage v4 is measured between the positive pole 124 and ground 136 on the load side 122 of the contactors 102 and 104.

In this example, the processing circuitry 106 is configured to calculate the first contactor voltage $V_{contactor1}$ across the positive contactor 102 based on the first voltage v1, the second voltage v2, and the fourth voltage v4. More specifically, by circuit analysis, the voltage between the positive pole 124 and ground 136 on the electrical energy storage system side 120 is the difference between the first voltage v1 and the second voltage v2. That is, the first contactor voltage, here in this example being the positive contactor 102 voltage is calculated as the difference the first voltage v1 and the second voltage v2 and the fourth voltage v4. This provides the voltage across the positive contactor 102.

Further, the processing circuitry 106 calculates the second contactor voltage $V_{contactor2}$, across the negative contactor 104 based on the second measured voltage v2, the third measured voltage v3, and the fourth measured voltage v3.

The voltage between the negative pole 126 and ground 136 on the load side 122 is the difference between the third voltage v3 and the fourth voltage v4. That is, the second contactor voltage, here in this example being the negative contactor 104 voltage is calculated as a difference, e.g., subtraction, between the third voltage v3 and the fourth voltage v4, and the second voltage v2. This provides the voltage across the negative contactor 104.

In this example, shown in fig. 4, the following equations apply:

$$V_{(negative)\_contactor2} = v3 - v4 - v2)$$

$$V_{(positive)\_contactor1} = v1 - v2 - v4$$

The evaluation in view of the voltage criterions and provision of output messages M apply in the same way in this example as in the above example described with reference to fig. 1.

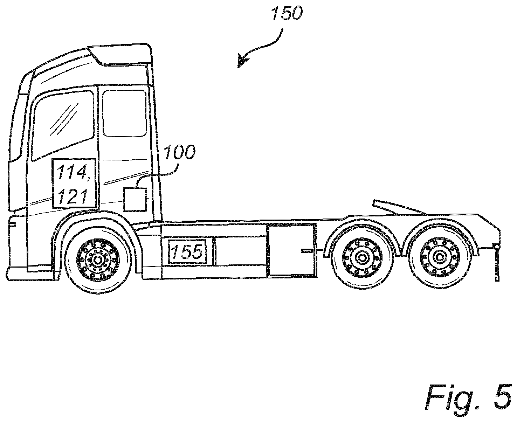

FIG. 5 illustrates a vehicle 150 according to examples of the present disclosure. The vehicle 150 is here shown as a heavy-duty truck but other types of vehicles are also applicable. The vehicle 150 comprises the computer system 100 and the electrical energy storage system 114 including the circuit 121. The vehicle 150 may comprise a hybrid-, or fully electric driveline 155 powered by the electrical energy storage system 114. The ground 136 referred to herein may be a chassis of the vehicle 150.

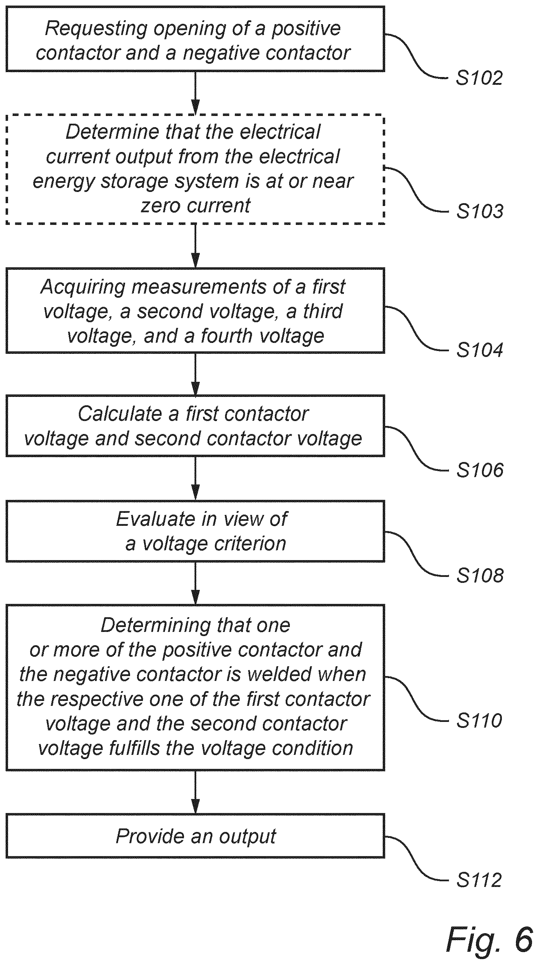

FIG. 6 is a flow-chart of method steps according to an example method for detecting welded contactors of an electrical energy storage system.

In step S102, requesting, by processing circuitry 106 of a computer system 100, opening of a positive contactor

102 and a negative contactor 104 arranged to controllably connect an electrical energy storage system 114 to a load 116.

In optional step S103, determining, by the processing circuitry 106, that the electrical current output from the electrical energy storage system 114 is at or near zero current.

In step S104, acquiring, by the processing circuitry 106, measurements of a first voltage v1 between the positive pole and the negative pole on the electrical energy storage system side 120 of the contactors, a second voltage v2 between one of the positive pole 124 or the negative pole 126 and ground 136 on the electrical energy storage system side 120 of the contactors, a third voltage v3 between the positive pole 126 and the negative pole 124 on the load side 122 of the contactors 102, 104, and a fourth voltage v4 between one of the positive pole 124 or the negative pole 126 and ground 136 on the load side 122 of the contactors 102, 104.

In step S106, calculating, by the processing circuitry 106, a first contactor voltage $V_{contactor1}$ across one of the negative contactor 104 and the positive contactor 102 and a second contactor voltage $V_{contactor2}$ across the other one of the negative contactor 104 and the positive contactor 102 based on the first measured voltage v1, the second measured voltage v2, the third measured voltage v3, and the fourth measured voltage v4.

In step S106, evaluating, by the processing circuitry 106, the first contactor voltage $V_{contactor1}$ and the second contactor voltage $V_{contactor2}$ in view of a voltage criterion.

In step S108, determining, by the processing circuitry 106, that one or more of the positive contactor 102 and the negative contactor 104 is welded when the respective one of the first contactor voltage $V_{contactor1}$ and the second contactor voltage $V_{contactor2}$ fulfills the voltage criterion.

In step S 112, providing, by the processing circuitry 106, an output *M* indicating that one or more of the positive contactor 102 and the negative contactor 104 is welded.

It is understood that further examples can be derived from the herein described specific examples. For example, the skilled person understands that, by reversing the sign of the voltage measurements and differences, further examples based on the same principle as herein described can be derived that are within the scope of the appended claims.

The measured voltages v1, v2, v3, v4 are voltages that may be used also for isolation resistance measurements. That means the resistance across which the voltages are measured, also indicated for clarity in the drawings, is the isolation resistance between poles and between poles and ground. In other words, no additional and actual resistor is added to the system for performing the weld test, instead, the same voltages measured for performing isolation resistance measurements are used also for the weld test described herein, no additional hardware is needed. Isolation resistance is the residual resistance between different points of a system.

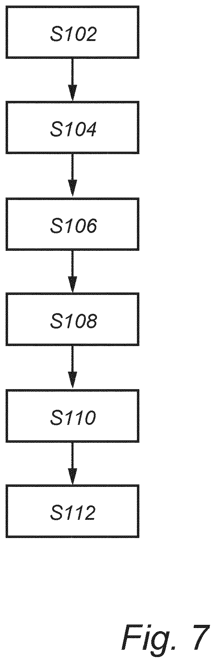

FIG. 7 is a flow-chart of method steps according to an example method for detecting welded contactors of an electrical energy storage system.

Requesting, in step S 102, by processing circuitry of a computer system, opening of a positive contactor and a negative contactor arranged to controllably connect an electrical energy storage system to a load,

Acquiring, in step S 104, by the processing circuitry, measurements of a first voltage between the positive pole and the negative pole on the electrical energy storage system side of the contactors, a second voltage between one of the positive pole the negative pole and ground on the electrical energy storage system side of the contactors, a third voltage across the negative pole and the positive pole on the load side of the contactors, and a fourth voltage between one of the positive pole or the negative pole and ground on the load side of the contactors,

Calculating in step S106, by the processing circuitry, a first contactor voltage across one of the negative contactor and the positive contactor and a second contactor voltage across the other one of the negative contactor and the positive contactor based on the first measured voltage, the second measured voltage, the third measured voltage, and the fourth measured voltage.

Evaluating, in step S 108, by the processing circuitry, the first contactor voltage and the second contactor voltage in view of a voltage criterion.

Determining, in step S110, by the processing circuitry, that one or more of the positive contactor and the negative contactor is welded when the respective one of the first contactor voltage and the second contactor voltage fulfills the voltage criterion.

Providing, in step S 112, by the processing circuitry, an output indicating that one or more of the positive contactor and the negative contactor is welded.

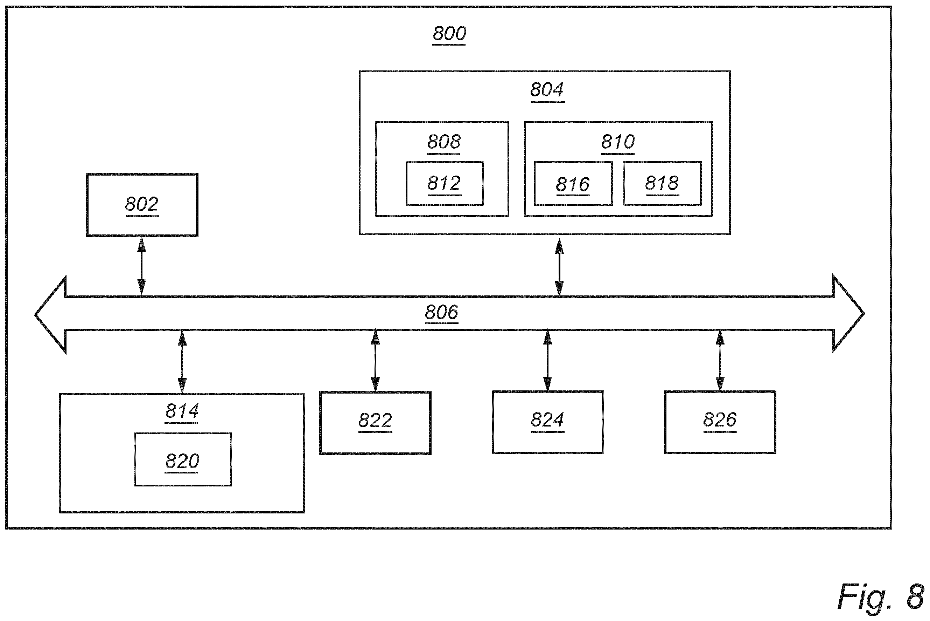

FIG. 8 is a schematic diagram of a computer system **800** for implementing examples disclosed herein. The computer system **800** is adapted to execute instructions from a computer-readable medium to perform these and/or any of the functions or processing described herein. The computer system **800** may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system **800** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **800** may comprise at least one computing device or electronic device capable of including firmware, hardware, and/or executing software instructions to implement the functionality described herein. The computer system **800** may include processing circuitry **802** (e.g., processing circuitry including one or more processor devices or control units), a memory **804,** and a system bus **806.** The computer system **800** may include at least one computing device having the processing circuitry **802.** The system bus **806** provides an interface for system components including, but not limited to, the memory **804** and the processing circuitry **802.** The processing circuitry **802** may include any number of hardware components for conducting data or signal processing or for executing computer code stored in memory **804.** The processing circuitry **802** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **802** may further include computer executable code that controls operation of the programmable device.

The system bus **806** may be any of several types of bus structures that may further interconnect to a memory bus (with or without a memory controller), a peripheral bus, and/or a local bus using any of a variety of bus architectures. The memory **804** may be one or more devices for storing data and/or computer code for completing or facilitating methods described herein. The memory **804** may include database components, object code components, script components, or other types of information structure for supporting the various activities herein. Any distributed or local memory device may be utilized with the systems and methods of this description. The memory **804** may be communicably connected to the processing circuitry **802** (e.g., via a circuit or any other wired, wireless, or network connection) and may include computer code for executing one or more processes described herein. The memory **804** may include non-volatile memory **808** (e.g., read-only memory (ROM), erasable programmable read-only memory (EPROM), electrically erasable programmable read-only memory (EEPROM), etc.), and volatile memory **810** (e.g., random-access memory (RAM)), or any other medium which can be used to carry or store desired program code in the form of machine-executable instructions or data structures and which can be accessed by a computer or other machine with processing circuitry **802.** A basic input/output system (BIOS) **812** may be stored in the non-volatile memory **808** and can include the basic routines that help to transfer information between elements within the computer system **800.**

The computer system **800** may further include or be coupled to a non-transitory computer-readable storage medium such as the storage device **814,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **814** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **814** and/or in the volatile memory **810,** which may include an operating system **816** and/or one or more program modules **818.** All or a portion of the examples disclosed herein may be implemented as a computer program **820** stored on a transitory or non-transitory computer-usable or computer-readable storage medium (e.g., single medium or multiple media), such as the storage device **814,** which includes complex programming instructions (e.g., complex computer-readable program code) to cause the processing circuitry **802** to carry out actions described herein. Thus, the computer-readable program code of the computer program **820** can comprise software instructions for implementing the functionality of the examples described herein when executed by the processing circuitry **802.** In some examples, the storage device **814** may be a computer program product (e.g., readable storage medium) storing the computer program **820** thereon, where at least a portion of a computer program **820** may be loadable (e.g., into a processor) for implementing the functionality of the examples described herein when executed by the processing circuitry **802.** The processing circuitry **802** may serve as a controller or control system for the computer system **800** that is to implement the functionality described herein.

The computer system **800** may include an input device interface **822** configured to receive input and selections to be communicated to the computer system **800** when executing instructions, such as from a keyboard, mouse, touch-sensitive surface, etc. Such input devices may be connected to the processing circuitry **802** through the input device interface **822** coupled to the system bus **806** but can be connected through other interfaces, such as a parallel port, an Institute of Electrical and Electronic Engineers (IEEE) 1394 serial port, a Universal Serial Bus (USB) port, an IR interface, and the like. The computer system **800** may include an output device interface **824** configured to forward output, such as to a display, a video display unit (e.g., a liquid crystal display (LCD) or a cathode ray tube (CRT)). The computer system **800** may include a communications interface **826** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

Example 1: A computer system comprising processing circuitry configured to: request opening of a positive contactor and a negative contactor arranged to controllably connect an electrical energy storage system to a load, acquire measurements of a first voltage between a positive pole and a negative pole on the electrical energy storage system side of the contactors, a second voltage between one of the positive pole or the negative pole and ground on the electrical energy storage system side of the contactors, a third voltage between the positive pole and the negative pole on the load side of the contactors, and a fourth voltage between one of the positive pole or the negative pole and ground on the load side of the contactors, calculate a first contactor voltage across one of the negative contactor and the positive contactor and a second contactor voltage across the other one of the negative contactor and the positive contactor based on the first measured voltage, the second measured voltage, the third measured voltage, and the fourth measured voltage, evaluate the first contactor voltage and the second contactor voltage in view of a voltage criterion, determine that one or more of the positive contactor and the negative contactor is welded when the respective one of the first contactor voltage and the second contactor voltage fulfill the voltage criterion, and provide an output indicating that one or more of the positive contactor and the negative contactor is welded.

Example 2: The computer system of example 1, wherein the voltage criterion is that one or more of the first contactor voltage the second contactor voltage is below or equal to a voltage threshold.

Example 3: The computer system of any of examples 1-2, wherein the voltage criterion is that one or more of the first contactor voltage and the second contactor voltage is close to zero.

Example 4: The computer system of any of examples 1-3, wherein the processing circuitry is further configured to: calculate the first contactor voltage as a difference between the second measured voltage and the fourth measured voltage.

Example 5: The computer system of any of examples 1-4, wherein the processing circuitry is further configured to: calculate the second contactor voltage as a difference between a first difference and a second difference, the first difference being the difference between the first voltage and the second voltage, and the second difference being the difference between the third voltage and the fourth voltage.

Example 6: The computer system of any of examples 1-5, the second voltage being measured between ground and the negative pole on the electrical energy storage system side of the contactors, and the fourth voltage being measured between ground and the negative pole on the load side of the contactors, the processing circuitry is configured to: calculate the first contactor voltage across the negative contactor as the difference between the fourth voltage and the second voltage, and calculate the second contactor voltage across the positive contactor as the difference between a first difference between the measured first voltage and the measured second voltage and a second difference between the measured third voltage and the measured fourth voltage.

Example 7: The computer system of any of examples 1-5, the second voltage being measured between the positive pole and ground on the electrical energy storage system side of the contactors, and the fourth voltage being measured between the positive pole and ground on the load side of the contactors, the processing circuitry is configured to: calculate the first contactor voltage across the positive contactor as the difference between the second voltage and the fourth voltage, and calculate the second contactor voltage across the negative contactor as the difference between a first difference between the measured third voltage and the measured fourth voltage and a second difference between the measured first voltage and the measured second voltage.

Example 8: The computer system of any of examples 1-7, wherein the electrical energy storage system is a propulsion electrical energy storage system of a vehicle.

Example 9: The computer system of any of examples 1-8, wherein the processing circuitry is further configured to: prior to acquiring the voltage measurements, determine that the electrical current output from the electrical energy storage system is at or near zero current.

Example 10: A vehicle comprising the computer system of any of examples 1-9.

Example 11: A computer-implemented method for detecting welded contactors of an electrical energy storage system, the method comprising: requesting, by processing circuitry of a computer system, opening of a positive contactor and a negative contactor arranged to controllably connect an electrical energy storage system to a load, acquiring, by the processing circuitry, measurements of a first voltage between the positive pole and the negative pole on the electrical energy storage system side of the contactors, a second voltage between one of the positive pole or the negative pole and ground on the electrical energy storage system side of the contactors, a third voltage between the positive pole and the negative pole on the load side of the contactors, and a fourth voltage between one of the positive pole or the negative pole and ground on the load side of the contactors, calculating, by the processing circuitry, a first contactor voltage across one of the negative contactor and the positive contactor and a second contactor voltage across the other one of the negative contactor and the positive contactor based on the first measured voltage, the second measured voltage, the third measured voltage, and the fourth measured voltage, evaluating, by the processing circuitry, the first contactor voltage and the second contactor voltage in view of a voltage criterion, determining, by the processing circuitry, that one or more of the positive contactor and the negative contactor is welded when the respective one of the first contactor voltage and the second contactor voltage fulfills the voltage criterion, and providing, by the processing circuitry, an output indicating that one or more of the positive contactor and the negative contactor is welded.

Example 12: The method of example 11, wherein the voltage criterion is that one or more of the first contactor voltage and the second contactor voltage is below or equal to a voltage threshold.

Example 13: The method of any of examples 11-12, wherein the voltage criterion is that one or more of the first contactor voltage the second contactor voltage is close to zero.

Example 14: The method of any of examples 11-13, further comprising: calculating, by the processing circuitry, the first contactor voltage as a difference between the second measured voltage and the fourth measured voltage.

Example 15: The method of any of examples 11-14, the method further comprising: calculating, by the processing circuitry, the second contactor voltage as a difference between a first difference and a second difference, the first difference being the difference between the first voltage and the second voltage, and the second difference being the difference between the third voltage and the fourth voltage.

Example 16: The method of any of examples 11-15, the second voltage being measured between ground and the negative pole on the electrical energy storage system side of the contactors, and the fourth voltage being measured between ground and the negative pole on the load side of the contactors, the method comprising: calculating, by the processing circuitry, the first contactor voltage across the negative contactor as the difference between the fourth voltage and the second voltage, and calculating, by the processing circuitry, the second contactor voltage across the positive contactor as the difference between a first difference between the measured first voltage and the measured second voltage and a second difference between the measured third voltage and the measured fourth voltage.

Example 17: The method of any of examples 11-15, the second voltage being measured between the positive pole and ground on the electrical energy storage system side of the contactors, and the fourth voltage being measured between the positive pole and ground on the load side of the contactors, the method comprising: calculating, by the processing circuitry, the first contactor voltage across the positive contactor as the difference between the second voltage and the fourth voltage, and calculating, by the processing circuitry, the second contactor voltage across the negative contactor as the difference between a first difference between the measured third voltage and the measured fourth voltage and a second difference between the measured first voltage and the measured second voltage.

Example 18: The method of any of examples 11-17, wherein the positive contactor and the negative contactor are requested to remain open throughout, and at least until the output is provided.

Example 19: The method of any of examples 11-18, comprising: prior to acquiring the voltage measurements, determining, by the processing circuitry, that the electrical current output from the electrical energy storage system is at or near zero current.

Example 20: The method of any of examples 11-19, wherein the electrical energy storage system is a propulsion electrical energy storage system of a vehicle.

Example 21: A computer program product comprising program code for performing, when executed by the processing circuitry, the method of any of examples 11-20.

Example 22: A non-transitory computer-readable storage medium comprising instructions, which when executed by the processing circuitry, cause the processing circuitry to perform the method of any of examples 11-20.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

**Claims**

1.   A computer system (100) comprising processing circuitry (106) configured to:

   request opening of a positive contactor (102) and a negative contactor (104) arranged to controllably connect an electrical energy storage system (114) to a load (116),
   acquire measurements of a first voltage (v1) between a positive pole (124) and a negative pole (126) on the electrical energy storage system side (120) of the contactors (102, 104), a second voltage (v2) between one of the positive pole or the negative pole (126) and ground on the electrical energy storage system side of the contactors, a third voltage between the positive pole and the negative pole (126) on the load side of the contactors, and a fourth voltage between one of the positive pole or the negative pole (126) and ground on the load side of the contactors (102, 104),
   calculate a first contactor voltage ($V_{contactor1}$) across one of the negative contactor (104) and the positive contactor (102) and a second contactor voltage ($V_{contactor2}$) across the other one of the negative contactor (104) and the positive contactor (102) based on the first measured voltage (v1), the second measured voltage (v2), the third measured voltage (v3), and the fourth measured voltage (v4),
   evaluate the first contactor voltage ($V_{contactor1}$) and the second contactor voltage ($V_{contactor2}$) in view of a voltage criterion,
   determine that one or more of the positive contactor (102) and the negative contactor (104) is welded when the respective one of the first contactor voltage ($V_{contactor1}$) and the second contactor voltage ($V_{contactor2}$) fulfill the voltage criterion, and
   provide an output (M) indicating that one or more of the positive contactor (102) and the negative contactor (104) is welded.

2.   The computer system (100) of claim 1, wherein the voltage criterion is that one or more of the first contactor voltage the second contactor voltage is below or equal to a voltage threshold.

3.   The computer system (100) of any of claims 1-2, wherein the voltage criterion is that one or more of the first contactor voltage and the second contactor voltage is close to zero.

4.   The computer system (100) of any of claims 1-3, wherein the processing circuitry (106) is further configured to:
   calculate the first contactor voltage as a difference between the second measured voltage and the fourth measured voltage.

5.   The computer system (100) of any of claims 1-4, wherein the processing circuitry (106) is further configured to:
   calculate the second contactor voltage as a difference between a first difference and a second difference, the first difference being the difference between the first voltage (v1) and the second voltage (v2), and the second difference being the difference between the third voltage (v3) and the fourth voltage (v4).

6.   The computer system (100) of any of claims 1-5, the second voltage (v2) being measured between ground and the negative pole (126) on the electrical energy storage system side of the contactors, and the fourth voltage (v4) being measured between ground and the negative pole (126) on the load side of the contactors, the processing circuitry (106) is configured to:

calculate the first contactor voltage across the negative contactor (104) as the difference between the fourth voltage (v4) and the second voltage (v2), and

calculate the second contactor voltage across the positive contactor (102) as the difference between a first difference between the measured first voltage (v1) and the measured second voltage (v2) and a second difference between the measured third voltage (v3) and the measured fourth voltage (v4).

7. The computer system (100) of any of claims 1-5, the second voltage (v2) being measured between the positive pole (124) and ground (136) on the electrical energy storage system side of the contactors, and the fourth voltage (v4) being measured between the positive pole (124) and ground on the load side of the contactors, the processing circuitry is configured to:

calculate the first contactor voltage across the positive contactor (102) as the difference between the second voltage (v2) and the fourth voltage (v4), and

calculate the second contactor voltage across the negative contactor (104) as the difference between a first difference between the measured third voltage (v3) and the measured fourth voltage (v4) and a second difference between the measured first voltage (v1) and the measured second voltage (v2).

8. The computer system (100) of any of claims 1-7, wherein the electrical energy storage system (114) is a propulsion electrical energy storage system of a vehicle.

9. The computer system (100) of any of claims 1-8, wherein the processing circuitry is further configured to:
prior to acquiring the voltage measurements, determine that the electrical current output from the electrical energy storage system is at or near zero current.

10. A vehicle (150) comprising the computer system of any of claims 1-9.

11. A computer-implemented method for detecting welded contactors of an electrical energy storage system, the method comprising:

requesting (S102), by processing circuitry of a computer system (100), opening of a positive contactor (102) and a negative contactor (104) arranged to controllably connect an electrical energy storage system to a load,
acquiring (S104), by the processing circuitry, measurements of a first voltage (v1) between the positive pole (124) and the negative pole (126) on the electrical energy storage system side of the contactors, a second voltage (v2) between one of the positive pole (124) or the negative pole (126) and ground on the electrical energy storage system side of the contactors, a third voltage (v3) between the positive pole (124) and the negative pole (126) on the load side of the contactors, and a fourth voltage (v4) between one of the positive pole (124) or the negative pole (126) and ground on the load side of the contactors,
calculating (S106), by the processing circuitry, a first contactor voltage across one of the negative contactor (104) and the positive contactor (102) and a second contactor voltage across the other one of the negative contactor (104) and the positive contactor (102) based on the first measured voltage, the second measured voltage, the third measured voltage, and the fourth measured voltage,
evaluating (S108), by the processing circuitry, the first contactor voltage and the second contactor voltage in view of a voltage criterion,
determining (S110), by the processing circuitry, that one or more of the positive contactor (102) and the negative contactor (104) is welded when the respective one of the first contactor voltage and the second contactor voltage fulfills the voltage criterion, and
providing (S112), by the processing circuitry, an output indicating that one or more of the positive contactor (102) and the negative contactor (104) is welded.

12. The method of claim 11, wherein the voltage criterion is that one or more of the first contactor voltage and the second contactor voltage is below or equal to a voltage threshold.

13. The method of any of claims 11-12, wherein the positive contactor (102) and the negative contactor (104) are requested to remain open throughout, and at least until the output is provided.

14. A computer program product (108) comprising program code for performing, when executed by the processing circuitry, the method of any of claims 11-13.

**15.** A non-transitory computer-readable storage medium (110) comprising instructions, which when executed by the processing circuitry, cause the processing circuitry to perform the method of any of claims 11-13.

Fig. 1

Fig. 2

EP 4 611 018 A1

Fig. 3

Fig. 4

*150*

*100*

*114, 121*

*155*

*Fig. 5*

Requesting opening of a positive
contactor and a negative contactor

—— S102

Determine that the electrical
current output from the electrical
energy storage system is at or near
zero current

—— S103

Acquiring measurements of a first
voltage, a second voltage, a third
voltage, and a fourth voltage

—— S104

Calculate a first contactor
voltage and second contactor voltage

—— S106

Evaluate in view of
a voltage criterion

—— S108

Determining that one
or more of the positive contactor and
the negative contactor is welded when
the respective one of the first contactor
voltage and the second contactor
voltage fulfills the voltage condition

—— S110

Provide an output

—— S112

Fig. 6

```
┌─────────────┐
│    S102     │
└─────────────┘
       │
       ▼
┌─────────────┐
│    S104     │
└─────────────┘
       │
       ▼
┌─────────────┐
│    S106     │
└─────────────┘
       │
       ▼
┌─────────────┐
│    S108     │
└─────────────┘
       │
       ▼
┌─────────────┐
│    S110     │
└─────────────┘
       │
       ▼
┌─────────────┐
│    S112     │
└─────────────┘
```

*Fig. 7*

*Fig. 8*

EP 4 611 018 A1

Europäisches
Patentamt

European
Patent Office

Office européen
des brevets

# EUROPEAN SEARCH REPORT

**Application Number**

EP 24 16 0406

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 10 2012 215190 A1 (BOSCH GMBH ROBERT [DE]; SAMSUNG SDI CO [KR]) 27 February 2014 (2014-02-27) * abstract; figure 1 * * paragraphs [0001] - [0010] * * paragraphs [0016] - [0023] * * paragraphs [0028] - [0037] * * claims 1-5 * | 1-15 | INV. H01H47/00 |
| A | DE 10 2015 008467 A1 (DAIMLER AG [DE]) 28 January 2016 (2016-01-28) * abstract; figure Fig. * * paragraphs [0001] - [0007] * * paragraphs [0011] - [0015], [0019] - [0040] * | 1-15 | |
| A | DE 10 2013 104629 A1 (REFUSOL GMBH [DE]) 6 November 2014 (2014-11-06) * abstract; figures 1,5 * * paragraphs [0002] - [0006], [0012], [0013], [0017] - [0019] * * paragraphs [0029] - [0031] * * paragraphs [0067] - [0071], [0089] - [0091] * | 1-15 | TECHNICAL FIELDS SEARCHED (IPC) H01H |
| A | EP 3 624 250 B1 (LG CHEMICAL LTD [KR]) 26 May 2021 (2021-05-26) * abstract; figures 1,3,6 * * paragraphs [0001] - [0009], [0013] - [0020] * * paragraphs [0031], [0033], [0035], [0036] - [0051] * * paragraphs [0053] - [0092], [0100], [0102] * | 1-15 | |

-/--

The present search report has been drawn up for all claims

| Place of search | Date of completion of the search | Examiner |
|---|---|---|
| Munich | 6 September 2024 | Bauer, Rodolphe |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

## EUROPEAN SEARCH REPORT

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ANONYMOUS: "SAE Electric Vehicle and Plug in Hybrid Electric Vehicle Conductive Charge Coupler", SAE STANDARD, SAE INTERNATIONAL, US , vol. J1772_201210 15 October 2012 (2012-10-15), pages 1-93, XP009502213, Retrieved from the Internet: URL:http://standards.sae.org/j1772_201210/ * Page 66 of 93, in particular t14' * ----- | 1-15 | |

TECHNICAL FIELDS
SEARCHED       (IPC)

The present search report has been drawn up for all claims

| Place of search | Date of completion of the search | Examiner |
|---|---|---|
| Munich | 6 September 2024 | Bauer, Rodolphe |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

## ANNEX TO THE EUROPEAN SEARCH REPORT
## ON EUROPEAN PATENT APPLICATION NO.

EP 24 16 0406

This annex lists the patent family members relating to the patent documents cited in the above-mentioned European search report.
The members are as contained in the European Patent Office EDP file on
The European Patent Office is in no way liable for these particulars which are merely given for the purpose of information.

06-09-2024

| Patent document cited in search report | Publication date | Patent family member(s) | | Publication date |
|---|---|---|---|---|
| DE 102012215190 A1 | 27-02-2014 | NONE | | |
| DE 102015008467 A1 | 28-01-2016 | NONE | | |
| DE 102013104629 A1 | 06-11-2014 | DE 102013104629 A1 | | 06-11-2014 |
| | | EP 2994767 A1 | | 16-03-2016 |
| | | US 2016099569 A1 | | 07-04-2016 |
| | | WO 2014180757 A1 | | 13-11-2014 |
| EP 3624250 B1 | 26-05-2021 | CN 110537287 A | | 03-12-2019 |
| | | EP 3624250 A1 | | 18-03-2020 |
| | | JP 7070973 B2 | | 18-05-2022 |
| | | JP 2020521415 A | | 16-07-2020 |
| | | KR 20190063266 A | | 07-06-2019 |
| | | PL 3624250 T3 | | 18-10-2021 |
| | | US 2020049770 A1 | | 13-02-2020 |
| | | WO 2019107976 A1 | | 06-06-2019 |

EPO FORM P0459

For more details about this annex : see Official Journal of the European Patent Office, No. 12/82